# EUROPEAN PATENT APPLICATION

(11) **EP 3 823 036 A1**
(43) Date of publication of application: **19.05.2021**
(21) Application number: 19209854.9
(22) Date of filing: 18.11.2019
(51) Int. Cl.: H01L 29/423, H01L 21/283, H01L 29/778, H01L 29/20

(54) **PROCESS FOR SCALING A GATE LENGTH**

(71) Applicant: Imec VZW, 3001 Leuven (BE)
(72) Inventor: WALDRON, Niamh, 3001 Leuven (BE); ALIAN, AliReza, 3001 Leuven (BE); PERALAGU, Uthayasankaran, 3001 Leuven (BE)
(74) Representative: DenK iP bv

(57) **Abstract**

A process comprising the steps of:
a. Providing a structure comprising:
i. a channel (3),
ii. a barrier (4),
iii. a non-conductive structure (13, 10) over the barrier, the non-conductive structure comprising a cavity having sidewalls separated by a first distance (Lstem),
b. Providing a first non-conductive layer conformally over the non-conductive structure, thereby covering the sidewalls and the bottom surface of the cavity,
c. Etching the first non-conductive layer in such a way that it is removed from at least part of the bottom surface but still covers the sidewalls,
d. Etching through the bottom surface at most until the channel is reached, by using the first non-conductive layer covering the sidewalls as a mask, thereby forming an opening in the bottom surface of the non-conductive structure, the opening having sidewalls separated by a second distance (Lg), smaller than the first distance, and
e. Completely removing the first non-conductive layer.

## Description

### Technical field of the invention

The present invention relates to processes for forming a field-effect transistor (FET), an intermediate for the formation thereof, and to field-effect transistors obtained by such processes. More in particular, the present invention is particularly well adapted for forming high electron mobility transistors (HEMTs) or metal insulator semiconductor high electron mobility transistors (MIS-HEMTs) having a small gate length.

### Background of the invention

In HEMT devices (e.g. GaN HEMT devices) used for radio frequency (RF) applications one major goal is to increase the current-gain cutoff frequency (fT) and the maximum oscillation frequency (fMAX) to allow for operation at mm-wave frequencies and to improve efficiency. One of the key technology drivers for higher performance is to scale the gate length (Lg) to shorter values. Reducing Lg comes with numerous challenges. Currently, many HEMT devices (e.g. GaN devices) are processed on maximum 200mm sized wafers where many fabs are limited in how far Lg can be reduced just by simple lithography. Also, although reducing Lg increases fT, it can also increase the gate resistance which would degrade fMAX. A shorter gate length also typically results in higher fields at the gate edges thereby increasing the gate leakage. Increased gate leakage increases power consumption and causes unwanted thermal heating of the devices when in the nominal *"off state".*

Shinohara K. et al. (Journal of the National Institute of Information and Communications Technology, Vol. 51, Nos. 1/2, 2004, pages 95-102) described a process for the fabrication of sub-50 nm gate InP-HEMT by an advanced lithography method involving the use of electron beam lithography where a tri-layer resist and a metal lift-off was used. First, the top and middle resist layers were exposed simultaneously at a relatively low dose, then developed with a high-sensitivity developer; next, the bottom layer was exposed at a relatively high dose and developed with a low-sensitivity developer. The control of Lg was achieved by optimizing the exposure and development conditions for the bottom layer resist. The gate was then filled by evaporating the gate metal.

However, this method is very tedious, labour-intensive, and requires a very delicate tuning of the exposure and development conditions. Furthermore, this technology is hardly compatible with VLSI manufacturing methods used for 200 mm wafers and above. There is, therefore, a need in the art for simpler methods, for achieving small Lgs in FETs in general and in HEMTs in particular.

### Summary of the invention

It is an object of the present invention to provide good field-effect transistors, intermediates in the fabrication thereof, and processes for forming the same.

The above objective is accomplished by processes and devices according to the present invention.

In a first aspect, the present invention relates to a process for forming an intermediate for the fabrication of a field-effect transistor, the process comprising the steps of:
a. Providing a semiconductor structure comprising:
   i. a semiconductor channel layer,
   ii. a barrier layer forming a heterojunction with the semiconductor channel layer, thereby creating a two-dimensional electron gas,
   iii. a non-conductive structure over the barrier layer, the non-conductive structure comprising a cavity having sidewalls and a bottom surface, the sidewalls being separated by a first distance,
b. Providing a first non-conductive layer conformally over the non-conductive structure, thereby covering the sidewalls and the bottom surface of the cavity,
c. Etching the first non-conductive layer in such a way that it is removed from at least part of the bottom surface but still covers the sidewalls,
d. Etching through the bottom surface at most until the semiconductor channel layer is reached, by using the first non-conductive layer covering the sidewalls as a mask, thereby forming an opening in the bottom surface of non-conductive structure, the opening having sidewalls separated by a second distance, smaller than the first distance, and
e. Completely removing the first non-conductive layer.

In a second aspect, the present invention may relate to a process for fabricating a field-effect transistor comprising the process according to the first aspect, and further comprising the steps of:
f. Providing a gate in the cavity and the opening, and
g. Providing a source and a drain.

In a third aspect, the present invention relates to a field-effect transistor comprising:
a. Semiconductor channel layer and a barrier layer forming together a heterojunction creating a two-dimensional electron gas,
b. a dielectric layer comprising a cavity having sidewalls and a bottom surface belonging to the barrier layer,
c. a second non-conductive layer, over the dielectric layer, conformally covering the sidewalls and the bottom surface of the cavity, thereby narrowing cavity to form a narrower cavity and defining a first distance between the sidewalls of the narrower cavity,
d. an opening in a part of the second non-conductive layer present on the bottom surface of the cavity, the opening having sidewalls separated by a second distance, smaller than the first distance,
e. A source electrode and a drain electrode, over the barrier layer, and
f. A gate filling the cavity and the opening, and situated between the source electrode and the drain electrode.

It is an advantage of the processes of the first and second aspect that they allow Lg scaling without the need for advanced lithography.

It is an advantage of the processes of the first and second aspects that they do not require an atomic layer deposition for providing a gate metal in the opening. Indeed, the cavity can be made wide enough, and the opening can be made shallow enough, for the gate metal to fill the opening by simpler deposition methods such as physical vapor deposition, ionized physical vapor deposition, or chemical vapor deposition.

It is an advantage of the processes of the second aspect that the gate length can be made arbitrary small without significant degradation of the gate resistance and hence Fmax. Indeed, the wider metal-filled cavity above the gate metal present in the opening permits to keep resistance low.

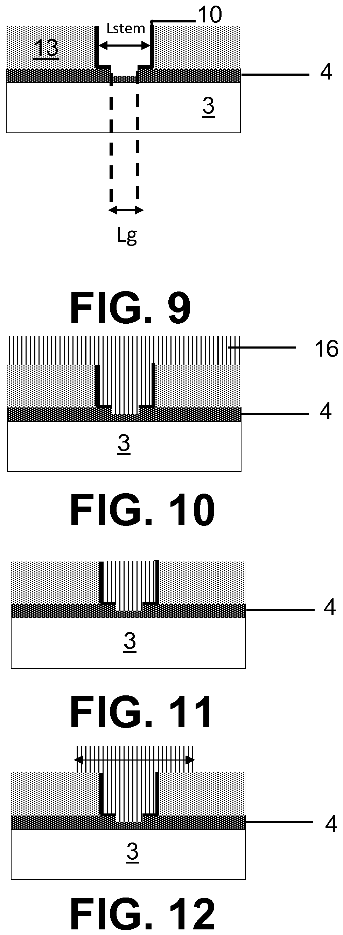

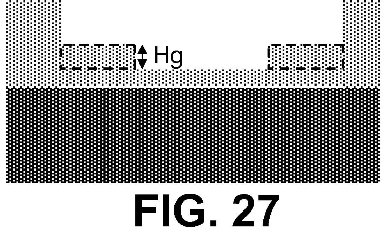

It is an advantage of embodiments of the different aspects of the present invention that the step present between the bottom of the cavity and the bottom of the opening can create non-conductive ledges on either side of the gate, thereby serving as gate edge termination suitable for reducing gate leakages. These ledges are present in FIGs 9,16, 24, and 26 and are delimited by dashed lines in FIG. 27.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1 is a schematic representation of a vertical cross-section through an assembly comprising a substrate, a buffer layer, a channel layer, and a barrier layer that may be used in any embodiment of the present invention.
FIGs. 2 and 3 are schematic representations of vertical cross-sections through intermediates in a process according to a first, a third, and a fourth illustrative embodiments of the present invention.
FIG. 4 is a schematic representation of a vertical cross-section through an intermediate which can be obtained as an alternative to the intermediate of FIG. 3 in the first, third, and fourth illustrative embodiments.
FIGs. 5-12 are schematic representations of vertical cross-sections through intermediates in a process according to the first illustrative embodiment.
FIGs. 13-16 are schematic representations of vertical cross-sections through intermediates in a process according to the second illustrative embodiment.
FIGs. 17-20 are schematic representations of vertical cross-sections through intermediates in a process according to the third illustrative embodiment.
FIGs. 21-24 are schematic representations of vertical cross-sections through intermediates in a process according to the fourth illustrative embodiment.
FIGs. 25-26 are alternatives to FIGs 19 and 20.
FIG. 27 is an enlarged portion of FIG. 26.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures, and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

Reference will be made to transistors. These are devices having a first main electrode such as a drain, a second main electrode such as a source and a control electrode such as a gate for controlling the flow of electrical charges between the first and second main electrodes.

It will be clear for a person skilled in the art that the present invention is also applicable to similar devices.

In a first aspect, the present invention relates to a process for forming an intermediate for the fabrication of a field-effect transistor, the process comprising the steps of:
a. Providing a semiconductor structure comprising:
   i. a semiconductor channel layer,
   ii. a barrier layer forming a heterojunction with the semiconductor channel layer, thereby creating a two-dimensional electron gas,
   iii. a non-conductive structure over the barrier layer, the non-conductive structure comprising a cavity having sidewalls and a bottom surface, the sidewalls being separated by a first distance,
b. Providing a first non-conductive layer conformally over the non-conductive structure, thereby covering the sidewalls and the bottom surface of the cavity,
c. Etching the first non-conductive layer in such a way that it is removed from at least part of the bottom surface but still covers the sidewalls,
d. Etching through the bottom surface at most until the semiconductor channel layer is reached, by using the first non-conductive layer covering the sidewalls as a mask, thereby forming an opening in the bottom surface of non-conductive structure, the opening having sidewalls separated by a second distance, smaller than the first distance, and
e. Completely removing the first non-conductive layer.

The process of the first aspect is compatible with the fabrication of any type of field-effect transistor. Indeed, although the semiconductor structure provided in step a comprises a heterojunction, step d of the first aspect allows etching through the bottom surface of the cavity until the semiconductor channel layer is reached. In such a case, the heterojunction is destroyed and the resulting field effect transistor is a metal-oxide semiconductor field-effect transistor (MOSFET). On another hand, if step d is stopped before the semiconductor channel layer is reached, the heterojunction is maintained and the transistor is a high electron mobility transistor (HEMT).

Hence, in an embodiment, the etching in step d may be stopped before the semiconductor channel layer is reached, and the field-effect transistor may be a high electron mobility transistor.

In all embodiments, the semiconductor structure provided in step a comprises a semiconductor channel layer. The semiconductor channel layer is typically a III-V channel layer. The III-V channel layer may be for instance a InₓGa₁₋ₓAs channel layer or a GaN channel layer. Preferably, it is a GaN channel layer.

In any embodiment, the thickness of the semiconductor channel layer may be from 5 to 1000 nm.

In all embodiments, the semiconductor structure provided in step a comprises a barrier layer. The barrier layer is such that it forms a heterojunction with the semiconductor channel layer, thereby creating a two-dimensional electron gas. For this purpose, the barrier layer is typically chosen to have a larger bandgap than the semiconductor channel layer. In the case of a GaN channel layer, a typical barrier layer would be an AlₓGa₁₋ₓN layer with an Al content (x) of from 5 to 40 at% or an InₓAl₁₋ₓN layer with an In content (x) of from 10 to 30 at%. Other barrier layers for a GaN channel layer are for instance InScAl barrier layers.

In any embodiment, the thickness of the barrier layer may be from 2 to 40 nm.

In any embodiment, a spacer layer may optionally be present between the semiconductor layer and the barrier layer. The spacer layer may for instance be an AIN layer.

In any embodiment, the thickness of the spacer layer may be from 0.5 to 3 nm.

In general, step a of providing the semiconductor structure may comprise providing the semiconductor structure on a substrate having a buffer layer thereon.

Hence, in any embodiment, step a may comprise the steps of providing a substrate, providing a buffer layer on the substrate, and providing the semiconductor structure on the buffer layer.

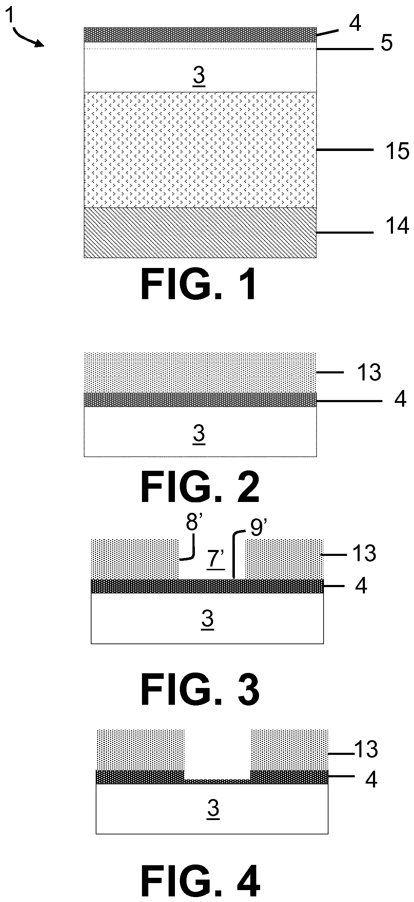

In any embodiment, as for instance illustrated in FIG. 1, step a may comprise providing a substrate (14), providing a buffer layer (15) on the substrate (14), providing a semiconductor channel layer (3) on the buffer layer, optionally providing a spacer layer on the channel layer (3), providing a barrier layer (4) on the spacer layer if present or on the channel layer (3), thereby creating a two-dimensional electron gas (5) in the semiconductor channel layer (3).

In FIG. 2-5, a non-conductive structure (2) is then provided on the barrier layer (4) according to a first illustrative embodiment.

In any embodiment, the substrate may be a semiconductor substrate such as a Si substrate, a SiC substrate, an AIN substrate, a GaAs substrate, an InP substrate, amongst others. In embodiments, the substrate may be a wafer having a diameter of 200 mm or more. For instance, it may be a Si wafer having a diameter of 200 mm or more.

In any embodiments where the substrate is Si and the channel layer is a GaN layer, the buffer layer may be an AIN layer, an AlₓGa₁₋ₓN layer, or a combination thereof. In embodiments, where the substrate is Si and the channel layer is a GaN layer, the buffer layer may comprise a bottom part, contacting the substrate, comprising an AIN layer, a AlₓGa₁₋ₓN layer, or a combination thereof, and an upper part, contacting the channel, comprising either a C-doped GaN layer or a Fe-doped GaN layer.

In any embodiment where the substrate is SiC and the channel layer is a GaN layer, the buffer layer may, for instance, be an AIN layer.

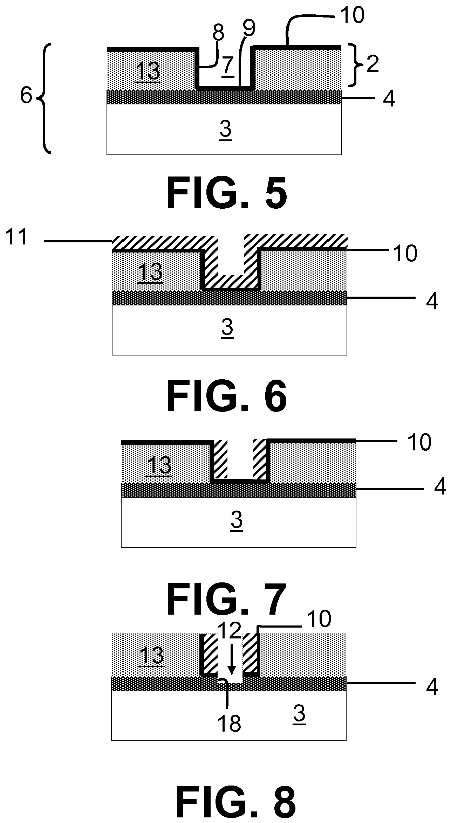

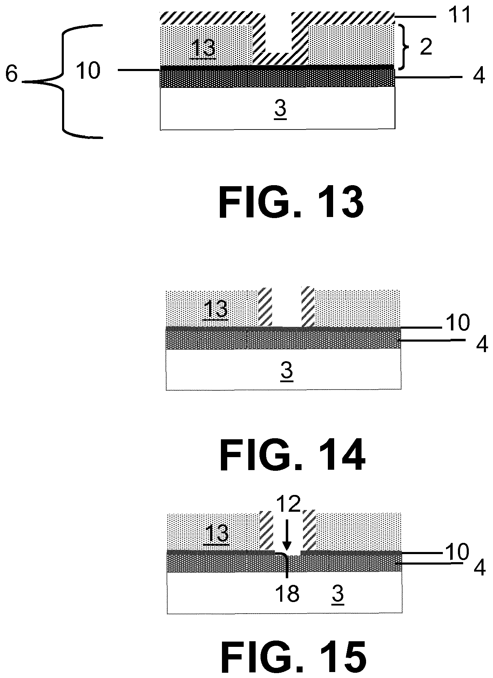

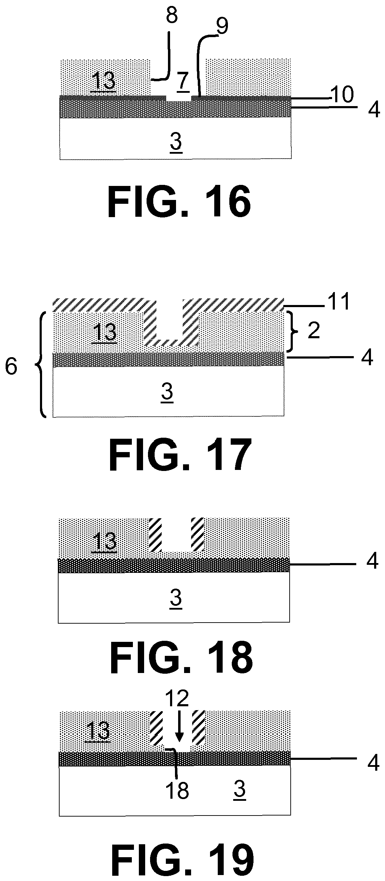

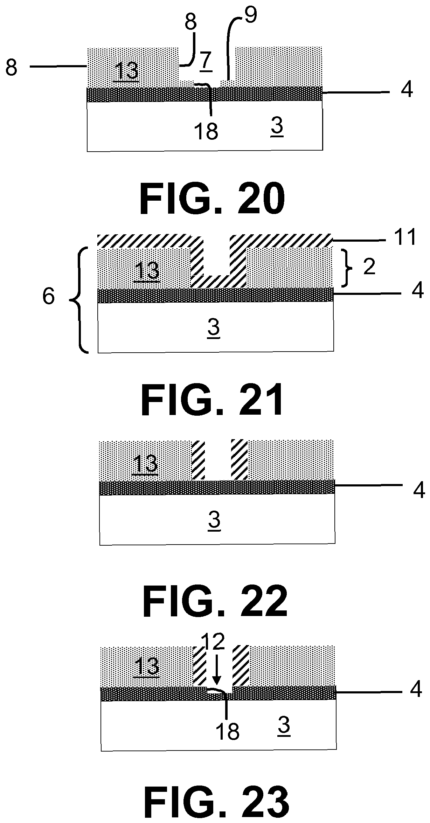

In any embodiment, the non-conductive structure provided in step a may consist of a single layer or may comprise a plurality of layers. FIGs 17 and 21 are examples where the non-conductive structure consists of a single layer. FIGs 5 and 13 are examples where the non-conductive structure comprises a plurality of layers. In any case, the non-conductive structure comprises at least a dielectric layer. The dielectric layer may, for instance, be a silicon oxide layer or a silicon nitride layer. The dielectric layer may, for instance, have a thickness of from 50 to 1000 nm. The dielectric layer may be on the barrier layer, as for instance in FIGs 5, 17 and 21 or may be over the barrier layer but separated therefrom by another layer (a second non-conductive layer), as for instance in FIG. 13.

In all embodiments, the dielectric layer comprises a cavity having sidewalls and a bottom surface. This cavity can be formed by lithography. Etching the dielectric layer to form the cavity may stop in the dielectric layer, as for instance in FIG. 17; on the barrier layer, as for instance in FIGs 5 and 21; in the barrier layer, as for instance in FIG. 4; on the second non-conductive layer, as for instance in FIG. 13; or even on the channel layer (not depicted). When the etching stops in a particular layer, the formed cavity has its bottom surface belonging to that layer.

In any embodiment, the distance separating the sidewalls of this cavity may, for instance, be from 50 to 1000 nm when the non-conductive structure will later be provided with a second non-conductive layer conformally on the dielectric layer, thereby narrowing the cavity to form a narrower cavity, as illustrated for instance in FIG. 5, before the performance of step b. Otherwise, when no such second non-conductive layer will be provided conformally on the dielectric layer, the distance separating the sidewalls of this cavity may, for instance, be from 46 to 900 nm.

The cavity comprised in the dielectric layer is the cavity comprised in the non-conductive structure in the cases where the non-conductive structure does not comprise a second non-conductive layer on the dielectric layer. In such cases, as for instance depicted in FIGs. 13, 17, and 21, the distance separating the sidewalls of this cavity is the first distance. This first distance may be from 46 to 900 nm.

When the non-conductive structure comprises a second non-conductive layer on the dielectric layer, however, as illustrated for instance in FIG. 5, the cavity present in the dielectric layer is not yet the cavity of non-conductive structure. In that case, the cavity of the non-conductive structure is the cavity present after the second non-conductive layer (having e.g. a thickness of from 2 to 50 nm) is conformally formed on the dielectric layer and the first distance may be from 46 to 900 nm.

A first distance of from 46 to 900 nm and a second distance, smaller than the first distance, have the advantage of allowing gate length scaling while simultaneously allowing:
- the relatively easy filling of the cavity and the opening without requiring elaborate methods such as atomic layer deposition,
- good gate conductance and hence high maximum oscillation frequency,
- the creation of a step, and hence ledges, which can serve as gate edge termination, thereby reducing gate leakage.

In some of the illustrative embodiments, that will now be presented, a second non-conductive layer is used. This second non-conductive layer can be a semi-conductive layer or a dielectric layer. If it is a semi-conductive layer, it is preferably a layer having a bandgap of at least 3 eV. Examples of suitable dielectric layers are silicon oxide, silicon nitride, aluminum oxide, and hafnium oxide. The second non-conductive layer is made of a material that can be etched selectively with respect to the first non-conductive layer used in step b. The first and the second non-conductive layers are therefore made of different materials. This permits the etching step c to be performed selectively. The thickness of the second non-conductive layer may be from 2 to 50 nm. The use of this second non-conductive layer has the advantage that the height of the sidewalls of the opening can be easily tailored in the range 2 to 50 nm by using a second non-conductive layer of corresponding thickness and by stopping the etching step d on the layer directly underlying the second non-conductive layer.

In a first illustrative embodiment shown in FIG. 5, the non-conductive structure (2) provided in step a may be formed of
- a dielectric layer (13) comprising a cavity (7', see FIG. 3) having sidewalls (8') and a bottom surface (9') belonging to the barrier layer (4), and
- a second non-conductive layer (10), over the dielectric layer (13), conformally covering the sidewalls (8') and the bottom surface (9') of the cavity (7'),
wherein the first non-conductive layer (11) provided in step b is provided on the second non-conductive layer (10).

We now refer to FIGs. 2 to 4 where the formation of the non-conductive structure (2) of this first illustrative embodiment is detailed. It may comprise the following steps. First, a dielectric layer (13) is provided over (and typically on) the barrier layer (4). Next, a cavity (7) is formed in the dielectric layer (13), stopping either on the barrier layer (4) (FIG. 3), in the barrier layer (4) (FIG. 4), or on the channel layer (3) (not depicted). We now refer to FIG. 5 where the second non-conductive layer (10) is provided over, and typically on the dielectric layer (13). This completes the non-conductive structure (2). The cavity (7) of the non-conductive structure (2) has sidewalls (8) made of the second non-conductive layer (10) and a bottom surface (9) which is also made of the second non-conductive layer (10). These sidewalls (8) are separated by the first distance (Lstem, see FIG. 9).

This first illustrative embodiment has the advantage that the height of the sidewalls of the opening can be easily tailored by using a second non-conductive layer of corresponding thickness. Furthermore, the opening is at least partially formed in the second non-conductive layer. When the second non-conductive layer is made of a dielectric material, the material forming the sidewalls of the opening, and which will serve as gate edge termination, is at least in part a dielectric material. Consequently, gate leakage will be relatively small.

In a second illustrative embodiment, depicted in FIG. 13 which shows the situation after step b, the semiconductor structure (2) provided in step a is formed of:
- a dielectric layer (13) comprising a cavity (7) having sidewalls (8) and a bottom surface (9), and
- a second non-conductive layer (10) between the barrier layer (4) and the dielectric layer (13), and wherein the bottom of the cavity (7) belongs to a top surface of the second non-conductive layer (10).

The formation of the non-conductive structure of this second illustrative embodiment is not depicted but may comprise the following steps. First, the second non-conductive layer is provided on the barrier layer. Second, a dielectric layer is provided on the second non-conductive layer. Next, a cavity is formed in the dielectric layer, stopping on the second non-conductive layer.

This second illustrative embodiment has the advantage that the height of the sidewalls of the opening can be easily tailored by using a second non-conductive layer of corresponding thickness. Furthermore, the opening is at least partially formed in the second non-conductive layer. When the second non-conductive layer is made of a dielectric material, the material forming the sidewalls of the opening, and which will serve as gate edge termination, is at least in part made of a dielectric material. Consequently, gate leakage will be relatively small.

In a third illustrative embodiment, depicted in FIG. 17 which shows the situation after step b, the non-conductive structure (2) provided in step a is formed of a single dielectric layer (13) (the *"dielectric layer (13)")* comprising a cavity (7) having sidewalls (8) and a bottom surface (9) belonging to the single dielectric layer (13).

The formation of the non-conductive structure of this third illustrative embodiment is not depicted but may comprise the following steps. First, a dielectric layer is provided on the barrier layer (as in FIG. 2). Next, a cavity is formed in the dielectric layer, stopping before to reach the barrier layer, i.e. stopping in the dielectric layer. This embodiment has the advantage that it does not require a first non-conductive layer. However, instead, a precisely timed etch is advantageous if a precise height for the opening sidewalls is to be obtained. Furthermore, the opening is at least partially formed in the dielectric layer. As a result, the material forming the sidewalls of the opening, and which will serve as gate edge termination, is at least in part a dielectric material. Consequently, gate leakage will be relatively small.

In a fourth illustrative embodiment, depicted in FIG. 21 which shows the situation after step b, the non-conductive structure (2) provided in step a is formed of a single dielectric layer (13) (the *"dielectric layer (13)")* comprising a cavity (7) having sidewalls (8) and a bottom surface (9) which belong to the barrier layer (4). For instance, the bottom surface (9) of the cavity (7) may be the top surface of the barrier layer (4).

The formation of the non-conductive structure of this fourth illustrative embodiment is depicted in FIGs 2-4 and comprises the following steps. First, a dielectric layer is provided on the barrier layer (as shown in FIG. 2). Next, a cavity is formed in the dielectric layer, stopping on the barrier layer (as shown in FIG. 3) or in the barrier layer (see FIG. 4).

This embodiment has the advantage that it does not require a first non-conductive layer. However, it requires instead a precisely timed etch if a precise height for the opening sidewalls is to be obtained. Furthermore, the opening is entirely formed in the barrier layer, which is a semiconductor layer. As a result, the material forming the sidewalls of the opening, and which will serve as gate edge termination, is a semiconductor material. Consequently, gate leakage might be higher than for the three other illustrative embodiments.

All embodiments of the first aspect of the present invention comprise a step b of providing a first non-conductive layer (11) conformally over the non-conductive structure (2), thereby covering the sidewalls (8) and the bottom surface (9) of the cavity (7) (see FIGs. 6, 13, 17, and 21).

In all embodiments, this step c may optionally comprise performing an anisotropic dry etch of the first non-conductive layer selectively with respect to the non-conductive structure.

This first non-conductive layer can be a semi-conductive layer or a dielectric layer. It is however preferably a dielectric layer. Examples of suitable dielectric layers are silicon oxide, silicon nitride aluminum oxide, and hafnium oxide. The thickness of the first non-conductive layer may be from 50 to 200 nm.

All embodiments of the first aspect of the present invention comprise a step c of etching the first non-conductive layer (11) in such a way that it is removed from at least part of the bottom surface (9) but still covers the sidewalls (8).

In the first illustrative embodiment, this step is depicted in FIG. 7 where the etching is performed until the second non-conductive layer (10), present at the bottom of the cavity (7), is exposed.

In the second illustrative embodiment, this step is depicted in FIG. 14 where the etching is performed until the second non-conductive layer (10), present at the bottom of the cavity (7), is exposed.

In the third illustrative embodiment, this step is depicted in FIG. 18 where the etching is performed until the dielectric layer (13), present at the bottom of the cavity (7), is exposed.

In the fourth illustrative embodiment, this step is depicted in FIG. 22 where the etching is performed until the barrier layer (4), present at the bottom of the cavity (7), is exposed.

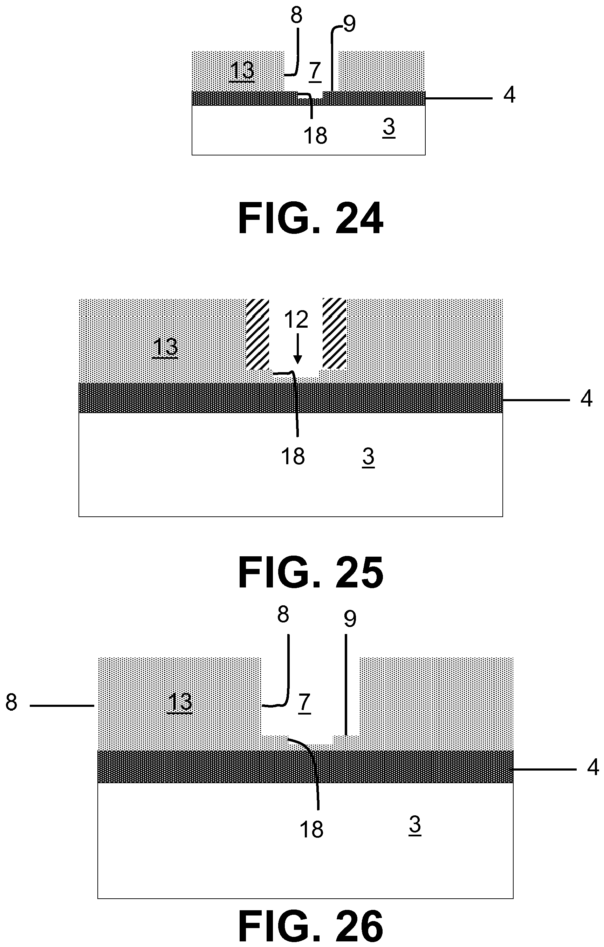

All embodiments of the first aspect of the present invention comprise a step d of etching through the bottom surface (9) of the cavity (7) at most until the semiconductor channel layer (3) is reached, by using the first non-conductive layer (11) covering the sidewalls (8) as a mask, thereby forming an opening (12) in the bottom surface (9) of non-conductive structure (2), the opening (12) having sidewalls (18) separated by a second distance (Lg), smaller than the first distance (Lstem). This etching can be stopped in a dielectric layer (13) (see for instance FIG. 25), on the barrier layer (4) (see for instance FIGs. 15 and 19), in the barrier layer (4) (see for instance FIG. 8 and 23), or on the channel layer (3) (not depicted).

In the first illustrative embodiment, this step is depicted in FIG. 8 where the etching is performed through the second non-conductive layer (10) at most until the channel layer is exposed. This step may stop in the second non-conductive layer (10), on the barrier layer (4), in the barrier layer (4) (as depicted in FIG. 8), or on the channel layer (3). If this step is stopped in the second non-conductive layer (10), and the second non-conductive layer (10) is a dielectric layer (13), the resulting structure is an intermediate (1) in the fabrication of a metal insulator semiconductor high electron mobility transistor.

In the second illustrative embodiment, this step is depicted in FIG. 15 where the etching is performed through the second non-conductive layer (10) at most until the channel layer (3) is exposed. This step may stop in the second non-conductive layer (10), on the barrier layer (4) (as depicted in FIG. 15), in the barrier layer (4), or on the channel layer (3). If this step is stopped in the second non-conductive layer (10), and the second non-conductive layer (10) is a dielectric layer (13), the resulting structure is an intermediate (1) in the fabrication of a metal insulator semiconductor high electron mobility transistor.

In the third illustrative embodiment, this step is depicted in FIGs. 19 and 25 where the etching is performed through the dielectric layer (13) at most until the channel layer (3) is exposed. This step may stop in the dielectric layer (13) (as depicted in Fig. 25), on the barrier layer (4) (as depicted in FIG. 19), in the barrier layer (4), or on the channel layer (3). If this step is stopped in the dielectric layer (13), the resulting structure is an intermediate (1) in the fabrication of a metal insulator semiconductor high electron mobility transistor.

In the fourth illustrative embodiment, this step is depicted in FIG. 23 where the etching is performed through at least part of the barrier layer (4) and at most until the channel layer (3) is exposed. This step may stop in the barrier layer (4) (as depicted in FIG. 23) or on the channel layer (3).

All embodiments of the first aspect of the present invention comprise a step e of completely removing the first non-conductive layer (11).

It is preferred if this first non-conductive layer (11) is removed selectively with respect to the non-conductive structure (2), the barrier layer (4) if exposed, and the channel layer (3) if exposed.

In embodiments where the second non-conductive layer (10) is present, the first non-conductive layer (11) is removed selectively with respect to the second non-conductive layer (10) (see FIGs. 9 and 16).

In the first illustrative embodiment, this step is depicted in FIG. 9 where the first non-conductive layer (11) is removed selectively with respect to the second non-conductive layer (10) and the barrier layer (4). The structure depicted in FIG. 9 shows the first (Lstem) and the second (Lg) distances resulting from the method.

In the second illustrative embodiment, this step is depicted in FIG. 16 where the first non-conductive layer (11) is removed selectively with respect to the second non-conductive layer (10), the dielectric layer (13), and the barrier layer (4).

In the third illustrative embodiment, this step is depicted in FIG. 20 where the first non-conductive layer (11) is removed selectively with respect to the dielectric layer (13), and the barrier layer (4).

FIG. 26 shows an alternative of the third illustrative embodiment where the first non-conductive layer (11) is removed selectively with respect to the dielectric layer (13). FIG. 27 shows an enlarged portion of FIG. 26 where the height (Hg) of the opening sidewalls (18) is defined.

In the fourth illustrative embodiment, this step is depicted in FIG. 24 where the first non-conductive layer (11) is removed selectively with respect to the dielectric layer (13), and the barrier layer (4).

In embodiments of the first aspect, the opening (12) may have sidewalls (18) having a height (Hg), measured perpendicularly to the bottom surface (9) of the non-conductive structure (2), of from 2 to 50 nm, preferably from 2 to 20 nm. Such a height (Hg) has the advantage to provide enough volume in the opening (12) to allow the formation of an efficient gate while simultaneously not being that high that the opening (12) cannot easily be filled.

In embodiments of the first aspect, the second distance (Lg) may be from 1 to 500 nm, preferably from 10 to 100 nm. Such a distance has the advantage to provide enough gate length. In embodiments, of the first aspect, Lg may be from 1 to 80% of Lstem, preferably from 20 to 80% of Lstem.

In a second aspect, the present invention may relate to a process for fabricating a field-effect transistor comprising the process according to the first aspect, and further comprising the steps of:
f. Providing a gate in the cavity and the opening, and
g. Providing a source and a drain.

Step f of providing a gate in the cavity and the opening typically comprises providing a gate metal in the cavity and the opening. In embodiments, it may further comprise lining the cavity and the opening with a gate dielectric before to fill them with a gate metal. In that last case, the field-effect transistor which is obtained is a metal insulator field-effect transistor; and if the obtained metal insulator field-effect transistor is a high electron mobility transistor (i.e. when step d stops before reaching the channel layer), it is a metal insulator semiconductor high electron mobility transistor. In embodiments, the thickness of the gate dielectric may be from 1 to 40nm. On another hand, when step f does not further comprise lining the cavity and the opening with a gate dielectric before to fill them with a gate metal, the device obtained is a field-effect transistor (all embodiments), a high electron mobility field-effect transistor (in all embodiments where step d stops after reaching the barrier layer but before reaching the channel layer), or a metal insulator semiconductor high electron mobility field-effect transistor (e.g. in the first, second, and third illustrative embodiments, when step d stops in a dielectric layer, e.g. in the second non-conductive layer in the case of the first and the second illustrative embodiments, or in the dielectric layer in the case of the third illustrative embodiment).

This step is well known to the person skilled in the art and is depicted for the first illustrative embodiment in FIGs 10-12.

First, the metal (16) is deposited in both the cavity (7) and the opening (12) (see FIG. 10). Second, the top surface of the metal (16) is recessed until the non-conductive structure (2) is exposed (see FIGs. 11 and 12). FIG. 11 shows an embodiment where the metal (16) is recessed by chemical mechanical planarization. FIG. 12 shows an embodiment where the metal layer is recessed by dry etching in such a way as to keep a metal cap of width larger than the first distance (Lstem) above the cavity (7). This has the advantage of still further decreasing the resistance.

The source and the drain are typically provided in step g on either side of the gate.

In a third aspect, the present invention relates to a field-effect transistor comprising
a. Semiconductor channel layer and a barrier layer forming together a heterojunction creating a two-dimensional electron gas,
b. a dielectric layer comprising a cavity having sidewalls and a bottom surface belonging to the barrier layer,
c. a second non-conductive layer, over the dielectric layer, conformally covering the sidewalls and the bottom surface of the cavity, thereby narrowing cavity to form a narrower cavity and defining a first distance between the sidewalls of the narrower cavity,
d. an opening in a part of the second non-conductive layer present on the bottom surface of the cavity, the opening having sidewalls separated by a second distance, smaller than the first distance,
e. A source electrode and a drain electrode, over the barrier layer, and
f. A gate filling the cavity and the opening, and situated between the source electrode and the drain electrode.

Other arrangements for accomplishing the objectives of the ... embodying the invention will be obvious for those skilled in the art.

It is to be understood that although preferred embodiments, specific constructions, and configurations, as well as materials, have been discussed herein for devices according to the present invention, various changes or modifications in form and detail may be made without departing from the scope of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A process for forming an intermediate (1) for the fabrication of a field-effect transistor, the process comprising the steps of:
a. Providing a semiconductor structure (6) comprising:
i. a semiconductor channel layer (3),
ii. a barrier layer (4) forming a heterojunction with the semiconductor channel layer (3), thereby creating a two-dimensional electron gas (5),
iii. a non-conductive structure (2) over the barrier layer (4), the non-conductive structure (2) comprising a cavity (7) having sidewalls (8) and a bottom surface (9), the sidewalls (8) being separated by a first distance (Lstem),
b. Providing a first non-conductive layer (11) conformally over the non-conductive structure (2), thereby covering the sidewalls (8) and the bottom surface (9) of the cavity (7),
c. Etching the first non-conductive layer (11) in such a way that it is removed from at least part of the bottom surface (9) but still covers the sidewalls (8),
d. Etching through the bottom surface (9) at most until the semiconductor channel layer (3) is reached, by using the first non-conductive layer (11) covering the sidewalls (8) as a mask, thereby forming an opening (12) in the bottom surface (9) of the non-conductive structure (2), the opening (12) having sidewalls (18) separated by a second distance (Lg), smaller than the first distance (Lstem), and
e. Completely removing the first non-conductive layer (11).

2. The process according to claim 1, wherein the etching in step d is stopped before the semiconductor channel layer (3) is reached and wherein the field-effect transistor is a high electron mobility transistor.

3. The process according to claim 2, wherein the etching in step d is stopped before the barrier layer (4) is reached and wherein the high electron mobility transistor is a metal insulator semiconductor high electron mobility transistor.

4. The process according to claim 1 or claim 2, wherein the bottom surface (9) of the cavity (7) belongs to the barrier layer (4).

5. The process according to claim 4, wherein the bottom surface (9) of the cavity (7) is a top surface of the barrier layer (4).

6. The process according to any one of claims 1 to 3, wherein the non-conductive structure (2) provided in step a is formed of
- a dielectric layer (13) comprising a cavity (7') having sidewalls (8') and a bottom surface (9') belonging to the barrier layer (4), and
- a second non-conductive layer (10), over the dielectric layer (13), conformally covering the sidewalls (8') and the bottom surface (9') of the cavity (7'),
wherein the first non-conductive layer (11) provided in step b is provided on the second non-conductive layer (10).

7. The process according to any one of claims 1 to 3, wherein the non-conductive structure (2) provided in step a is formed of:
a. a dielectric layer (13) comprising a cavity (7) having sidewalls (8) and a bottom surface (9), and
b. a second non-conductive layer (10) between the barrier layer (4) and the dielectric layer (13), and wherein the bottom of the cavity (7) belongs to a top surface of the second non-conductive layer (10).

8. The process according to claim 6 or claim 7, wherein the first non-conductive layer (11) is made of a dielectric material.

9. The process according to any one of claims 1 to 3, wherein the non-conductive structure (2) provided in step a is formed of a single dielectric layer (13) comprising a cavity (7) having sidewalls (8) and a bottom surface (9) belonging to the single dielectric layer (13).

10. The process according to any one of the preceding claims, wherein the opening (12) has sidewalls (18) having a height (Hg), measured perpendicularly to the bottom surface (9) of the non-conductive structure (2), of from 2 to 50 nm, preferably from 2 to 20 nm.

11. The process according to any one of the preceding claims, wherein the first distance (Lstem) is from 46 to 900 nm.

12. The process according to any one of the preceding claims, wherein the first distance (Lstem) is at least 10% larger than the second distance (Lg).

13. The process according to any one of the preceding claims, wherein the second distance (Lg) is from 1 to 500 nm, preferably from 1 to 20 nm.

14. The process according to any one of the preceding claims, wherein the second non-conductive layer (10) is made of a dielectric material.

15. A process for fabricating a field-effect transistor comprising the process according to any of the preceding claims, and further comprising the steps of:
f. Providing a gate in the cavity (7) and the opening (12), and
g. Providing a source and a drain.

16. A field-effect transistor comprising
a. Semiconductor channel layer (3) and a barrier layer (4) forming together a heterojunction creating a two-dimensional electron gas (5),
b. a dielectric layer (13) comprising a cavity (7') having sidewalls (8') and a bottom surface (9') belonging to the barrier layer (4),
c. a second non-conductive layer (10), over the dielectric layer (13), conformally covering the sidewalls (8') and the bottom surface (9') of the cavity (7'), thereby narrowing cavity (7') to form a narrower cavity (7) and defining a first distance (Lstem) between the sidewalls (8) of the narrower cavity (7),
d. an opening (12) in a part of the second non-conductive layer (10) present on the bottom surface (9') of the cavity (7'), the opening (12) having sidewalls (18) separated by a second distance (Lg), smaller than the first distance (Lstem),
e. A source electrode and a drain electrode, over the barrier layer (4), and
f. A gate filling the cavity (7) and the opening (12) and situated between the source electrode and the drain electrode.
